# EUROPÄISCHE PATENTSCHRIFT

(11) **EP 0 334 392 B1**
(45) Veröffentlichungstag und Bekanntmachung des Hinweises auf die Patenterteilung: **24.02.1993**
(21) Anmeldenummer: 89108452.7
(22) Anmeldetag: 24.07.1986
(51) Int. Cl.: G11B 7/08

(54) **Optische Abtasteinheit**
Optical scanning unit
Unité de balayage optique

(30) Priorität: 14.08.1985 DE 3529090; 14.08.1985 DE 3529091; 25.11.1985 NL 8503238
(43) Veröffentlichungstag der Anmeldung: 27.09.1989
(62) Teilanmeldung aus: 86201316.6
(73) Patentinhaber: Philips Patentverwaltung GmbH, 22335 Hamburg (DE); Philips Electronics N.V., 5621 BA Eindhoven (NL)
(72) Erfinder: Meyer, Karl-Hanns, Dr., D-5100 Aachen (DE); Honds, Leo, D-5100 Aachen (DE)
(74) Vertreter: Kupfermann, Fritz-Joachim, Dipl.-Ing.

(56) Entgegenhaltungen:
- EP-A- 0 070 070
- EP-A- 0 103 929
- EP-A- 0 133 994
- US-A- 4 421 997
- PATENT ABSTRACTS OF JAPAN vol. 8, no. 175 (P-294)(1612) 11 August 1984, & JP-A-59 068839 (ALPS DENKI K.K.) 18 April 1984,
- PATENT ABSTRACTS OF JAPAN vol. 9, no. 195 (P-379)(1918) 13 August 1985, & JP-A-60 061927 (HITACHI SEISAKUSHO K.K.) 09 April 1985,
- PATENT ABSTRACTS OF JAPAN vol. 7, no. 125 (P-200)(1270) 31 Mai 1983, & JP-A-58 41449 (NIPPON VICTOR K.K.) 10 März 1983,
- PATENT ABSTRACTS OF JAPAN vol. 7, no. 23 (P-171)(1168) 29 Januar 1983, & JP-A-57 176541 (CANON K.K.) 29 Oktober 1982,
- PATENT ABSTRACTS OF JAPAN vol. 6, no. 145 (P-132)(1023) 04 August 1982, & JP-A-57 066536 (NIPPON VICTOR K.K.) 22 April 1982,
- PATENT ABSTRACTS OF JAPAN vol. 8, no. 31 (P-253)(1468) 09 Februar 1984, & JP-A-58 185042 (MITSUBISHI DENKI K.K.) 28 Oktober 1983,
- PATENT ABSTRACTS OF JAPAN vol. 9, no. 144 (P-365)(1867) 19 Juni 1985, & JP-A-60 022744 (OLYMPUS KOGAKU KOGYO K.K.) 05 Februar 1985,

## Beschreibung

Die Erfindung bezieht sich auf eine optische Abtasteinheit zum Steuern und Richten eines Strahlungsbündels auf Aufzeichnungsspuren einer abzutastenden Oberfläche eines Informationsträgers, wobei die Abtasteinheit ein Objektiv mit einer optischen Achse aufweist, das mit einer Objektivlinse zum Fokussieren des Strahlungsbündels zu einem Abtastfleck auf der genannten Oberfläche versehen ist, wobei die Abtasteinheit weiterhin eine elektromagnetische Antriebsvorrichtung zum ständigen Korrigieren der Lage des Objektivs gegenüber dem Informationsträger aufweist, wobei die Antriebsvorrichtung mit einer Objektivhalterung für das Objektiv versehen ist, wobei diese Objektivhalterung einen koaxial zu der optischen Achse angeordneten, beweglichen ringförmigen Körper aufweist, der an den axialen Enden mit zueinander entgegengesetzt magnetisierten Magnetpolen versehen ist und aus axial aufeinander gesetzten, dauermagnetischen Teilen besteht, und wobei die Antriebsvorrichtung weiterhin mit ortsfesten Spulen versehen ist, die über einen Luftspalt mit dem genannten Magnetkörper magnetisch zusammenarbeiten und die mindestens drei Spulensätze aus jeweils zwei Segmentspulen aufweisen, wobei diese Sätze, in der Umfangsrichtung des Magnetkörpers gesehen, in untereinander gleichen Abständen nebeneinander angeordnet sind.

Eine derartige optische Abtasteinheit ist aus der DE-PS 32 34 288 bekannt. Bei dieser bekannten Abtasteinheit ist das Objektiv in einer beweglichen, axial dauermagnetisierten Hülse mit zwei als magnetische Pole ausgebildeten axialen Enden befestigt. Die fest angeordneten Segmentspulen sind als flache, bananenförmig gebogene Spulen mit zwei gegenüber einander und gegenüber der genannten Hülse sich koaxial erstreckenden Spulenteilen ausgebildet, wobei bei Stromdurchgang durch die Segmentspulen der Strom in den betreffenden Spulenteilen in der entgegengesetzten Richtung geht.

Mit der bekannten Anordnung der Spulen lassen sich drei entsprechend den drei Koordinatenachsen eines orthogonalen Achsensystems gerichtete Kräfte sowie zwei um zwei der genannten Koordinatenachsen wirksame Drehmomente erzeugen.

Mit Hilfe der Antriebsvorrichtung der bekannten Abtasteinheit sind im Grunde alle erwünschten Bewegungen des Objektivs verwirklichbar. Diese Bewegungen umfassen eine axiale Bewegung, die parallel zu der optischen Achse des Objektivs verläuft und die zum Fokussieren eines Lichtfleckes eines Lichtbündels auf eine Informationsfläche einer sich drehenden optischen Platte dient, sowie zwei senkrecht zu aufeinander verlaufende radiale Bewegungen und/oder zwei Kippbewegungen um zwei senkrecht zueinander und zu der optischen Achse verlaufenden Achsen, wobei die letztgenannten vier Bewegungen zur radialen und tangentialen Spurfolge des Lichtflecks dienen.

Die bekannte Antriebseinheit weist jedoch den Nachteil auf, daß die magnetischen Kräfte zwischen den Spulen und der magnetischen Hülse als Funktion der axialen Verschiebung des Objektivs derart schwanken, daß bereits bei einer geringen axialen Verschiebung des Objektivs aus der Mitte zwischen den Spulensätzen liegenden Mittellage die Antriebsvorrichtung nicht mehr imstande ist, das Objektiv noch einwandfrei zu verschieben, um die erforderliche Fokussierung des Lichtbündels sowie die erforderliche Spurfolge des Lichtflecks zu verwirklichen. Die weit auseinander angeordneten Spulensätze eignen sich zwar dazu, sich über einen ausreichenden Abstand längs der optischen Achse zu bewegen; dabei nimmt aber die Möglichkeit, die anderen genannten Bewegungen zu erzeugen, so schnell ab, daß das Objektiv bereits in einem geringen Abstand von der Mittellage nicht mehr ausreichend angetrieben wird, um die Spurfolge des Lichtflecks gewährleisten zu können.

Die Erfindung hat nun zur Aufgabe, eine optische Abtasteinheit der eingangs erwähnten Art zu schaffen, die derart mit Spulen versehen ist, daß die zur Fokussierbewegung sowie die zur Spurfolge erforderlichen Kräfte beim über einen größeren Abstand Verschieben des Objektivs konstant oder nahezu konstant bleiben.

Die erfindungsgemäße optische Abtasteinheit weist dazu das Kennzeichen auf, daß jede einzelne Segmentspule zwei sich im gleichen Abstand vom Magnetkörper um diesen erstreckende, axial auseinander liegende aktive Spulenteile aufweist, wobei einer dieser Spulenteile sich in der Nähe eines axialen Endes des in der Mittellage befindlichen Magnetkörpers befindet und der andere axial in Richtung auf die Magnetkörpermitte versetzt ist, wobei die beiden genannten Spulenteile durch axial verlaufende Spulenteile verbunden sind.

Bei dieser Abtasteinheit sind außer den senkrecht aufeinander stehenden Berwegungskomponenten auch zwei Drehmomente um zwei dieser Achsen möglich. Es handelt sich damit um einen Fünfachsaktuator.

Nach einer weiteren Ausführungsform der Erfindung ist vorgesehen, daß sich rings um die Magnetkörpermitte in einer Radialebene eine Ringspule erstreckt, die sich zwischen den genannten Segmentspulen der Spulensätze befindet. Mittels der Ringspule läßt sich die axiale Stellkomponente verstärken.

Nach einer weiteren Ausgestaltung der Erfindung ist vorgesehen, daß alle Segmentspulen der Segmentspulensätze und die Ringspule aus flächenhaften Leitungszügen bestehen, die auf einem zylinderförmigen Träger vorgesehen sind, der den Magnetkörper umschließt. Auf diese Weise lassen sich die Spulen außerordentlich flach ausbilden und auf einem Zylindermantel aufbauen. Die Herstellung der Spulensätze ist technisch einfach zu handhaben und eignet sich gut für eine Massenfertigung.

Nach einer weiteren Ausgestaltung der Erfindung ist vorgesehen, daß zwischen den dauermagnetischen Teilen des Magnetkörpers ein Zwischenteil angeordnet ist, das unmagnetisch, weichmagnetisch oder ebenfalls dauermagnetisch ausgebildet ist.

Ist das Zwischenteil unmagnetisch, dann lassen sich die Kraftwirkungen in axialer und radialer Richtung stärker voneinander trennen. Ist das Zwischenteil ferromagnetisch, dann läßt sich die Radialkomponente verstärken. Ist das Zwischenteil dauermagnetisch, dann läßt sich die Radialkomponente noch mehr verstärken. Insgesamt gilt, daß sich durch das Einführen des Zwischenteiles Eigenschaften des Systems (Magnet/Spulenkonfiguration) erreichen lassen, die ohne Zwischenteil nicht erreichbar sind.

Nach einer weiteren Ausgestaltung der Erfindung ist vorgesehen, daß die Teile des Magnetkörpers einander entgegengesetzt dauermagnetisch magnetisieret sind. Diese Art der Magnetisierung läßt sich technisch am einfachsten realisieren.

Nach einer anderen Ausgestaltung der Erfindung ist vorgesehen, daß die Norpole der Teile des Magnetkörpers in Richtung auf das Zwischenteil und die Nordpole des Zwischenteiles zu seiner Außenwand orientiert sind. Ebensogut ist es umgekehrt möglich, die Nordpolorientierung derart umzukehren, daß die Nordpole der Teil zu den axialen Enden und die Nordpole der Zwischenteile zu seiner Innenwand orientiert sind.

Ausführungsbeispiele der Erfindung sind in der Zeichnung dargestellt und werden im folgenden näher beschrieben. Es zeigen.
Fig. 1 eine schematische Darstellung eines Teils der erfindungsgemäßen Abtasteinheit,
Fig. 2 einen Schnitt durch eine optische Abtasteinheit mit einem zweiteiligen dauermagnetischen Magnetkörper, der als Objektivträger ein Fokusobjektiv trägt, mit außerhalb des Magnetkörpers angeordneten Spulensätzen im Bereich der axialen Enden und einer Ringspule im Bereich der radialen Mittelebene, die sich zwischen den Spulensätzen befindet,
Fig. 3 eine vereinfachte schaubildliche Darstellung der Ausführungsform nach Fig. 2,
Fig. 4 die Darstellung einer Segmentspule des Spulensatzes nach Fig. 3 mit den von dieser Segmentspule ausgehenden Steuerkräften,
Fig. 5 einen Schnitt durch eine abgewandelte optische Abtasteinheit mit den Spulen und den Magnetfeldern des Magnetkörpers,
Fig. 6 eine Abwandlung des aus zwei Magnetteilen bestehenden Magnetkörpers mit einem Zwischenteil zwischen beiden Magnetteilen,
Fig. 7 schaubildlich den Aufbau der Spulensätze nach Fig. 5 und des in den Spulensätzen angeordneten Magnetkörpers,
Fig. 8 eine Segmentspule eines Spulensatzes nach Fig. 7 mit der von ihr ausgehenden Kraftwirkung.

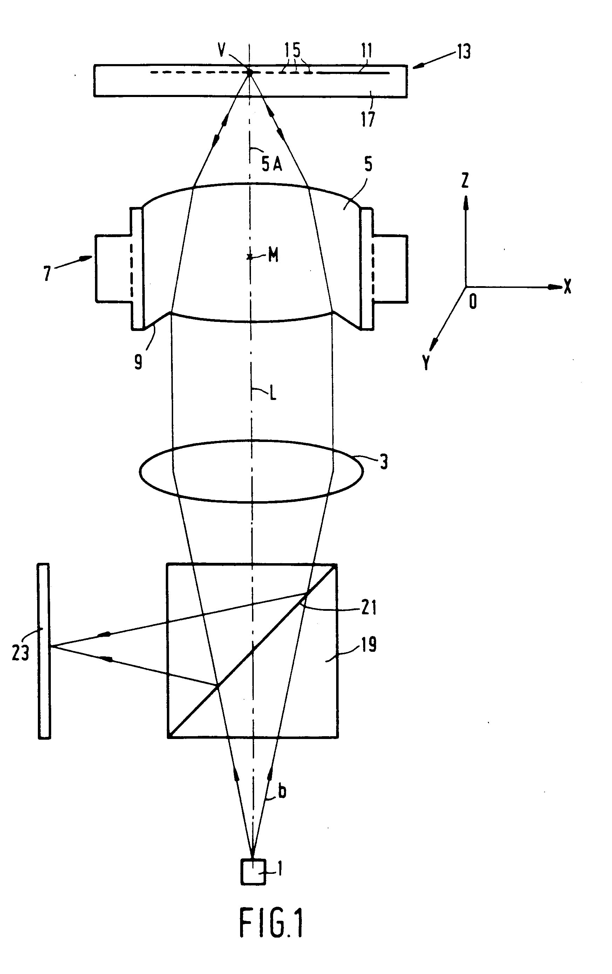

Die Abtasteinheit nach Fig. 1 ist mit einer Strahlungsquelle 1, beispielsweise einem Diodenlaser, einer Kollimatorlinse 3 und einem Objektiv 5 mit einer optischen Achse 5A versehen, wobei das Objektiv in einer Objektivhalterung 7 einer noch näher zu beschreibenden elektromagnetischen Antriebsvorrichtung angeordnet ist. Die Kollimatorlinse 3 sowie das Objektiv 5 können mehrere Linsenelemente aufweisen, bestehen aber vorzugsweise aus einem einzigen Linsenelement mit mindestens einer asphärisch brechenden Oberfläche. In dieser Anordnung besteht das Objektiv aus nur einer Objektivlinse, die entsprechend einem Replika-Verfahren hergestellt wurde, wobei die Objektivlinse mit einem ringförmigen Spiegel 9 zwecks eines an dieser Stelle nicht näher beschriebenen Lagendetektionssystems versehen ist. Ein derartiges Lagendetektionssystem ist in der NL-PA 85 01 665 eingehend beschrieben. Das von der Strahlungsquelle 1 gelieferte divergierende Strahlungsbündel b wird von der Kollimatorlinse 3 zu einem parallelen Bündel umgewandelt, das die Öffnung des Objektivs 5 auf einwandfreie Weise füllt. Das Objektiv fokussiert das Strahlungsbündel zu einem biegungsbegrenzten Strahlungsfleck V mit einem Durchmesser von beispielsweise 1 µm in der Informationsfläche 11 eines scheibenförmigen Informationsträgers 13, von dem in Fig. 1 ein kleiner Teil in radialem Schnitt dargestellt ist. Die Information ist in konzentrischen Spuren 15 oder quasi-konzentrischen Spuren, die zusammen eine spiralförmige Spur bilden, gegliedert. Die Information besteht aus einer Vielzahl optisch detektierbarer Informationsgebiete, zwischen denen Zwischengebiete liegen. Vorzugsweise befindet sich die Informationsfläche 11 in der Nähe der Oberseite des Informationsträgers 13, so daß das Bündel b durch das durchsichtige Substrat 17 des Informationsträgers geht, bevor es die Informationsfläche erreicht. Die Informationsfläche ist vorzugsweise strahlungsreflektierend, so daß das Bündel in der Richtung der Strahlungsquelle reflektiert wird.

Bei drehendem Informationsträger ist das von der Informationsfläche reflektierte Bündel in der Zeit moduliert, und zwar entsprechend der Folge von Informationsgebieten und Zwischengebieten in der auszulesenden Spur. Um das modulierte Bündel von dem von der Strahlungsquelle ausgestrahlten Bündel zu trennen, ist in dem Strahlungsweg ein Auskoppelelement 19 in Form beispielsweise eines Teilprismas vorgesehen, dessen Trennfläche 21 mindestens einen Teil des zurückgeworfenen Bündels zu dem strahlungsempfindlichen Detektor 23 reflektiert. Der Detektor 23 verwandelt das modulierte Bündel in ein elektrisches Signal, das auf bekannte Weise zu einem Signal verarbeitet wird, das, abhängig von der Art der Information, die in dem Informationsträger gespeichert ist, dazu geeignet ist, sichtbar oder hörbar gemacht oder aber auf eine andere Art und Weise verarbeitet zu werden.

In dem rechten Teil der Fig. 1 ist ein Achsensystem XYZ angegeben, dessen Ursprung O als im Punkt M gedacht werden muß, so daß die Z-Achse mit dem Hauptstrahl L des Bündels b zusammenfällt. Die Z-Achse erstreckt sich in axialer Richtung, wobei dies die Richtung ist, in der das Objektiv verschoben werden muß, um das Bündel b zu dem Lichtfleck V zu fokussieren. Die X-Achse und die Y-Achse erstrecken sich in radialer Richtung bzw. in tangentialer Richtung gegenüber der Drehungsachse des Informationsträgers. Weil der Lichtfleck V den Spuren der sich drehenden Informationsplatte möglichst gut folgen soll, ist es notwendig, daß das Objektiv 5 geradlinige Bewegungen entsprechend der X-Achse und der Y-Achse sowie etwaige Drehungen um diese Achsen durchführen kann. Die Bewegung des Objektivs gemäß der Z-Achse wird auch als Fokussierbewegung bezeichnet, während die übrigen Bewegungen auch als Spurfolge- und Zeitfehlerkorrigierbewegungen bezeichnet werden.

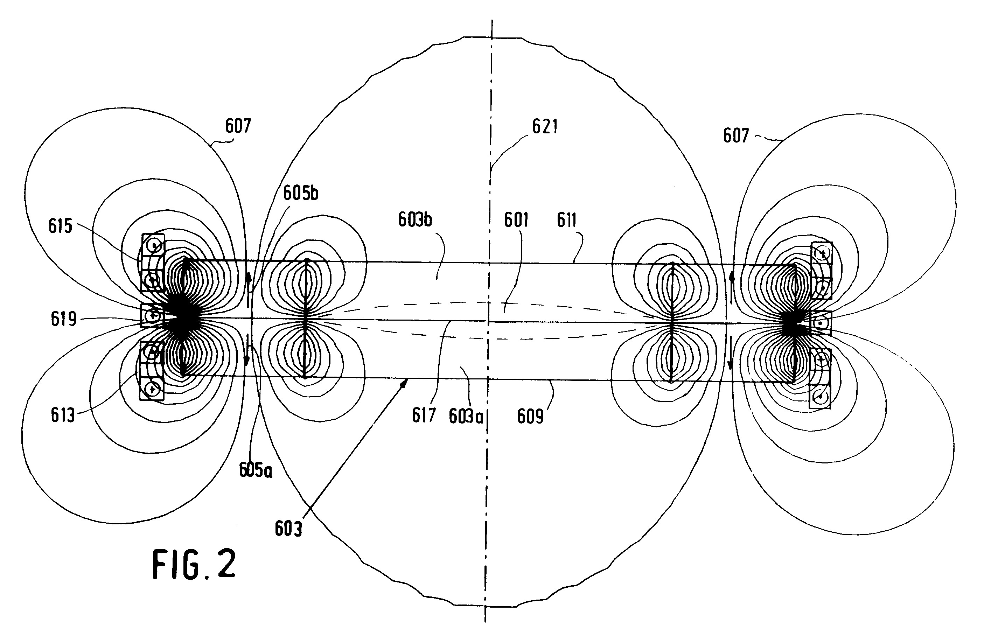

Bei der in Fig. 2 dargestellten optischen Abtasteinheit ist ein Fokusobjektiv 601, schematisch angedeutet durch strichpunktierte Linien, in einem dauermagnetischen Magnetkörper 603 angeordnet. Dieser Magnetkörper besteht aus zwei Magnetteilen 603a und 603b. Beide Teile 603a und 603b sind in entgegengesetzter Richtung axial magnetisiert, was durch die Pfeile 605b und 605a wiedergegeben wird. Aufgrund der durch die Pfeile 605a und 605b wiedergegebenen Magnetisierung ergibt sich außerhalb des Magnetkörpers 603 ein Magnetfeld, welches durch die Magnetfeldlinien 607 angedeutet ist.

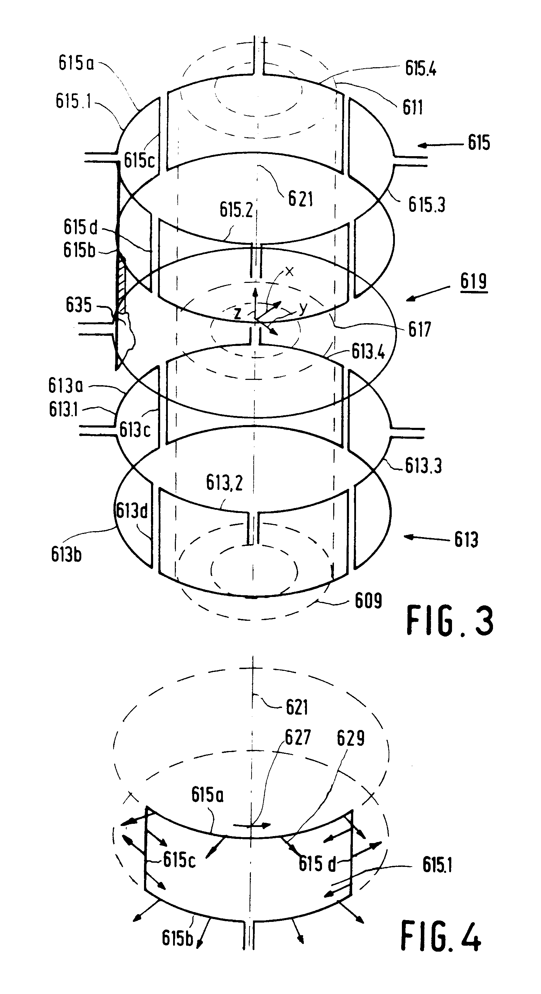

Um den Magnetkörper 603 herum sind im Bereich seiner axialen Enden 609, 611 Spulensätze 613, 615 und im Bereich der Verbindungsfläche 617 zwischen den Magnetteilen 603a und 603b eine Ringspule 619 angeordnet. Der Aufbau der Gesamtspulenanordnung ist in Fig. 3 schaubildlich dargestellt. Dabei ist zur Vrdeutlichung der Spulenaufbau insgesamt stark in die Länge gezogen. In dem ausgeführten Beispiel sind Spulenanordnung und axiale Hülsenlänge nur wenige Millimeter hoch.

Um den in Fig. 3 nur schematisch angedeuteten dauermagnetischen Magnetkörper 603 erstrecken sich die Spulensätze 613 und 615, zwischen denen die Ringspule 619 vorgesehen ist. Die Spulensätze 613 und 615 sind einander entsprechend ausgebildet.

Jeder der Spulensätze 613, 615 besteht aus mehreren Segmentspulen 615.1, 615.2, 615.3, 615.4 bzw. 613.1, 613.2, 613.3, 613.4. Die einzelnen Segmentspulen sind als Zylindermantelabschnitte ausgebildet, die sich in Zylinderumfangsrichtung zu einem Zylindermantel ergänzen. Hierzu besteht jede einzelne Segmentspule 613.1 bis 615.4 aus zwei bogenförmigen Spulenteilen 613a, 613b bzw. 615a, 615b. Die jeweiligen Spulenteile 613a bzw. 615a bilden dabei zusammen einen aus Teilen zusammengesetzten oberen Spulenring, während alle Spulenabschnitte 613b bzw. 615b gemeinsam einen aus Teilen zusammengesetzten unteren Spulenring ausbilden. Alle Spulenteile 613a, 613b und 615a, 615b haben die gleiche Krümmung und liegen alle etwa gleich weit von der Vorrichtungsachse 621 entfernt. Bei jeder Segmentspule 613.1 bis 615.4 sind die Spulenteile 613a und 613b bzw. 615a und 615b über Verbindungsteile 613c und 613d bzw. 615c und 615d miteinander verbunden. Diese Verbindungsteile verlaufen in Richtung bzw. parallel zur Vorrichtungsachse 621. Die Verbindungsteile 613c, 613d bzw. 615c, 615d sind für die Steuerung nahezu unbedeutend, während die Spulenteile 613a und 613b, 615a und 615b zur Steuerung der Stellung des Magnetkörpers 603 innerhalb der Spulenanordnung gemeinsam beitragen. Durch unterschiedliche Ansteuerung der einzelnen Segmentspulen ist eine Verschiebung in den Koordinationsachsen X, Y, Z möglich, außerdem eine Drehung des Körpers 603 um zwei dieser Achsen.

Fig. 4 zeigt anhand einer einzelnen Segmentspule 615.1 bei einem Stromverlauf in Richtung eines Pfeiles 627 anhand mehrerer Pfeile 629 die Kraftwirkungen, die von den einzelnen Spulenteilen 715a und 715b bzw. den Verbindungsteilen 615c und 615d ausgehen. Die Kraftwirkungen, die von den Verbindungsteilen 615c und 615d ausgehen, heben sich offensichtlich auf. Das bedeutet, daß die Kraftwirkungen von den parallel zu der Vorrichtungsachse verlaufenden Verbindungsteilen zur Steuerung des Magnetkörpers weder positiv noch negativ beitragen. Anders ist es bei den Spulenteilen 615a und 615b. Die von diesen Spulenteilen ausgehenden Pfeile zeigen, daß bei einer Stromrichtung, die durch den Pfeil 627 angegeben ist, die Kraftwirkungen dieser Spulenteile nach außen verlaufen. Würde der Strom in umgekehrter Richtung durch die Spule 615.1 fließen, dann wären die Kraftwirkungen nach innen gerichtet. Durch eine entsprechende Ansteuerung der einzelnen Spulenteile läßt sich damit eine Verstellung des Magnetkörpers innerhalb der Spulenanordnung erreichen.

Die Spulen 613.1 bis. 613.4; 615.1 bis 615.4; 715.1 bis 715.4 und 619 der optischen Einheit können als flächenhafte Leitungszüge auf einem Isolierzylinder 635, beispielsweise aus Hartpapier oder dergl., aufgebaut und angebracht sein. Ein derartiger, in Fig. 3 angedeuteter Aufbau ist einfach und für die Massenfertigung geeignet.

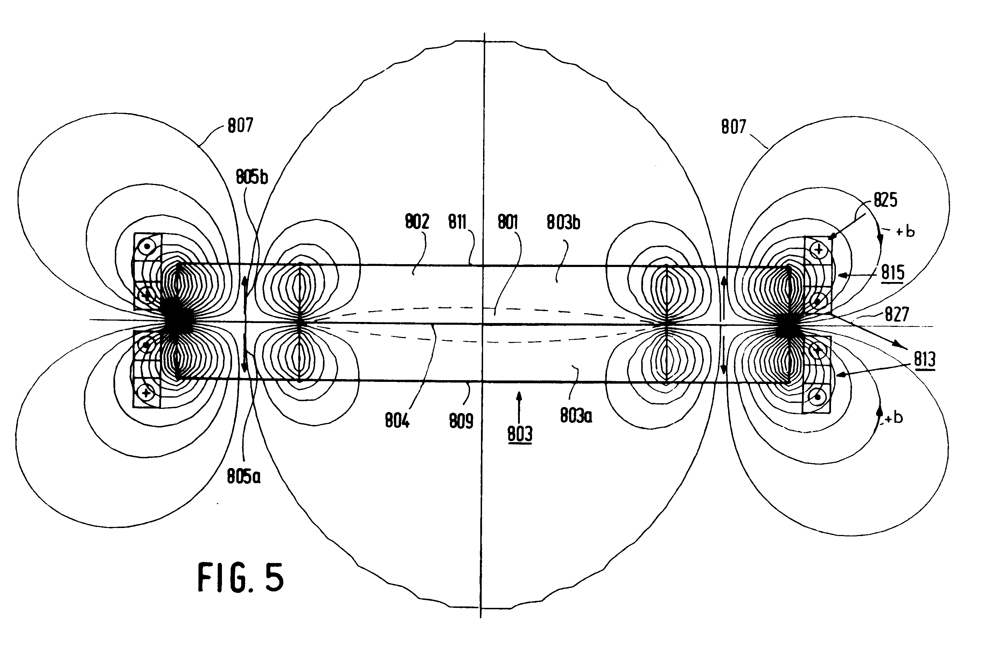

Das durch eine gestrichelte Linie in Fig. 5 angedeutete Fokusobjektiv 801 ist im Inneren 802 eines dauermagnetischen Magnetkörpers 803 angeordnet. Der Magnetkörper besteht aus zwei Magnetteilen 803a und 803b, die längs einer Fläche 804 miteinander verbunden sind, beispielsweise durch Verkleben. Die dauermagnetischen Magnetteile 803a und 803b sind axial in entgegengesetzten Richtungen magnetisiert. Die Magnetisierungsrichtung ist durch Pfeile 805a und 805b angedeutet. Das Magnetfeld, das sich rings um den Magnetkörper 803 ausgebildet, ist durch die Magnetfeldlinien 807 angedeutet. Infolge der Magnetisierung in entgegengesetzten Richtungen befinden sich die Nordpole der Magnetteile 803a und 803b im Bereich der axialen Enden 809 und 811.

Rings um den Magnetkörper 803 erstrecken sich in einem Abstand, der ein freies Bewegen des Magnetkörpers 803 zuläßt, zwei Segmentspulensätze 813 und 815. Der Segmentspulensatz 813 und der Segmentspulensatz 815 umgeben etwa das axiale Ende 811.

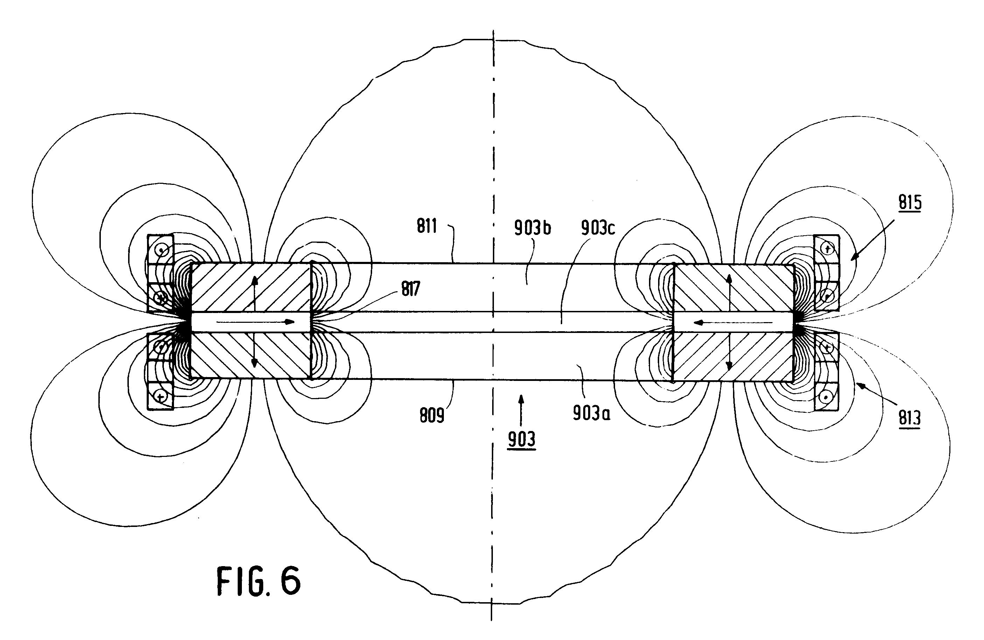

Wie sich aus Fig. 6 ergibt, kann der Magnetkörper 903 auch aus zwei Magnetteilen 903a und 903b bestehen, zwischen denen sich ein Zwischenteil 903c befindet. Die Magnetisierung ist dabei in dem Ausführungsbeispiel nach Fig. 6 so gewählt, daß die Magnetteile 903a und 903b entsprechend der Magnetisierung nach Fig. 5 zu den axialen Enden 809 und 811 hin magnetisiert sind. Der Zwischenteil ist in diesem Fall in Richtung auf ihre Innenwand 817 hin magnetisiert. Diese Magnetisierungsrichtungen bedeuten, daß sich die Nordpole der Magnetteile 903a und 903b an den axialen Enden 809 und 811 und die Nordpole des Zwischenteiles 903c an der Innenwand 817 des Zwischenteiles befinden. Die Anordnung der Segmentspulensätze 813 und 815 entspricht bei dem Ausführungsbeispiel nach Fig. 6 der Anordnung dieser Segmentspulensätze in Fig. 5.

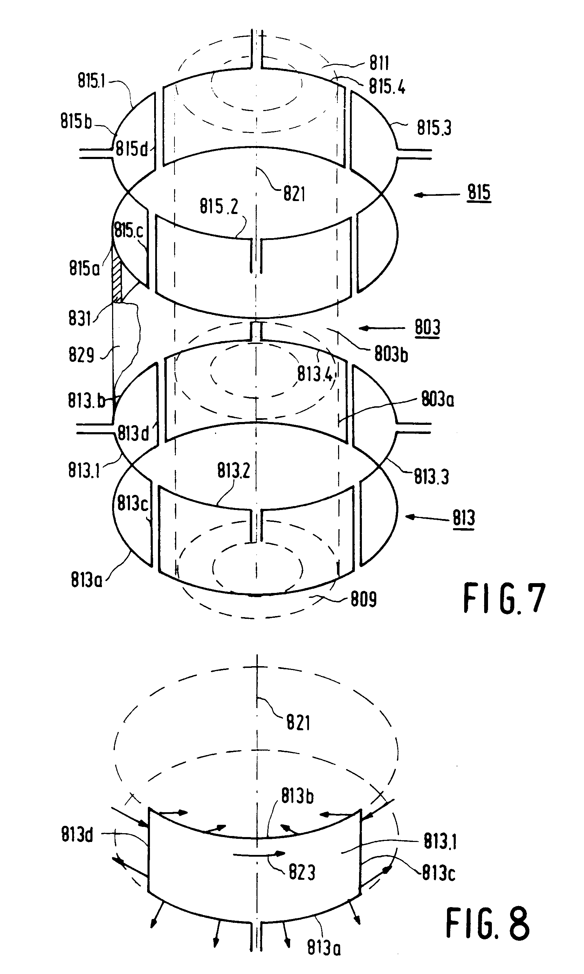

Fig. 7 zeigt anhand einer schaubildlichen Darstellung in axialer Richtung auseinandergezogen die den Magnetkörper 803 umgebende Spulenanordnung. Der Magnetkörper 803 ist nur mit seinen Magnetteilen 803a und 803b sowie mit seinen axialen Enden 809 und 811 angedeutet. Die Segmentspulensätze 813 und 815 bestehen jeweils aus vier Segmentspulen. So besteht der Segmentspulensatz 813 aus den Segmentspulen 813.1, 813.1, 813.3, 813.4. Der Segmentspulensatz 815 besteht aus den vier Segmentspulen 815.1, 815.2, 815.3, 815.4. Jede Segmentspule 813.1 bis 815.4 ist wie ein Zylidnermantelabschnitt ausgebildet. Alle Segmentspulen 813.1 bis 813.4 und 815.1 bis 815.4 ergeben zusammengesetzt zwei Zylinderspulenmäntel, die öaxial gegeneinander versetzt den Magnetkörper 803 umgeben.

Jede einzelne Segmentspuale 813.1 bis 813.4 bzw. 815.1 bis 815.4 besteht aus in gleicher Weise gekrümmten und axial gegeneinander versetzten Spulenteilen 813a und 813b bzw. 815a und 815b. Alle Spulenteile 813a, 813b und 815a, 815b aller Segmentspulen 813.1 bis 815.4 sind gleich weit von der Vorrichtungsachse 821 entfernt und wirken dementsprechend alle steuernd auf den Magnetkörper 803.

Die Spulenteile 813a und 813b sowie 815a und 815b aller einzelner Spulen sind über Verbindungsteile 813c und 813d bzw. 815c und 815d miteinander verbunden. Diese Verbindungsteile 813c und 813d bzw. 815c und 815d verlaufen parallel zur Vorrichtungsachse 821. Die Verbindungsteile von benachbarten Segmentspulen liegen unmittelbar nebeneinander. Wie später noch erläutert wird, haben diese Verbindungsteile kaum einen Einfluß auf die Steuerung bzw. Verstellung des Magnetkörpers 803.

Fig. 8 zeigt eine Segmentspule 813.1 in schaubildlicher Darstellung, die repräsentativ ist für alle eingesetzten Segmentspulen 813.1 bis 815.4. Diese Segmentspulen weisen, wie sich aus Fig. 7 ergibt, um die Vorrichtungsachse 821 gekrümmte Spulenteile 813a und 813b auf, die über die Verbindungsteile 813c und 813d miteinander verbunden sind. Die Segmentspule 813.1 ist in Richtung eines Pfeiles 823 stromdurchflossen. Bei diesem Stromdurchfluß ergibt es sich, daß die Feldkräfte des Spulenteiles 813a nach außen und unten und die Feldkräfte des Spulenteiles 813a nach innen und unten gerichtet sind. Die Feldkräfte der Verbindungsteile 813c und 813d verlaufen in Umfangsrichtung auseinander. Der Kräfteverlauf zeigt, daß die Kraftwirkungen der Verbindungsteile 813c und 813d sich rings um die einzelnen Segmentspulen gegeneinander aufheben und damit wirkungslos sind. Die Kraftwirkungen der Spulenteile 813a und 813b hingegen lassen sich zu einer steuernden Einflußnahme auf den Magnetkörper ausnutzen.

In Fig. 5 sind mit Hilfe der Pfeile 825 und 827 von einer der Segmentspulen des Segmentspulensatzes ausgehende Feldkräfte dargestellt. Auch hieraus lassen sich die auf den Magnetkörper 803 ausgeübten Feldkräfte ableiten. Die Pfeile +b geben den Verlauf des Feldflusses längs der Feldlinie wieder.

Der Aufbau der Spulenanordnung der optischen Einheit ist für die Massenfertigung besonders geeignet, wenn alle Spulen 813.1 bis 815.4 beispielsweise nach Art flächenhafter Leitungszüge auf die Oberfläche 829 eines in Fig. 7 angedeuteten Isolierzylinders 831 beispielsweise aus Hartpapier oder dergl. aufgebracht werden.

## Patentansprüche

1. Optische Abtasteinheit zum Steuern und Richten eines Strahlungsbündels auf Aufzeichnungsspuren einer abzutastenden Oberfläche eines Informationsträgers, wobei die Abtasteinheit ein Objektiv mit einer optischen Achse aufweist, das mit einer Objektivlinse zum Fokussieren des Strahlungsbündels zu einem Abtastflecken auf der genannten Oberfläche versehen ist, wobei die Abtasteinheit weiterhin eine elektromagnetische Antriebsvorrichtung zum ständigen Korrigieren der Lage des Objektivs gegenüber dem Informationsträger aufweist, wobei die Antriebsvorrichtung mit einer Objektivhalterung für das Objektiv versehen ist, wobei diese Objektivhalterung einen koaxial zu der optischen Achse angeordneten, beweglichen ringförmigen Körper (603) aufweist, der an den axialen Enden mit zueinander entgegengesetzt magnetisierten Magnetpolen versehen ist und aus axial aufeinander gesetzten dauermagnetischen Teilen besteht, und wobei die Antriebsvorrichtung weiterhin mit ortsfesten Spulen versehen ist, die über einen Luftspalt mit dem genannten Magnetkörper magnetisch zusammenarbeiten und die mindestens drei Segmentspulensätze aus jeweils zwei Segmentspulen (z. B. 613.1, 615.1) aufweisen, wobei diese Sätze, in der Umfangsrichtung des Magnetkörpers gesehen, in untereinander gleichen Abständen nebeneinander angeordnet sind, dadurch gekennzeichnet, daß jede einzelne Segmentspule (z. B. 613.1) zwei sich im gleichen Abstand vom Magnetkörper um diesen erstreckende, axial auseinander liegende aktive Spulenteile (613a, 613b) aufweist, wobei einer dieser Spulenteile sich in der Nähe eines axialen Endes des in der Mittellage befindlichen Magnetkörpers befindet und der andere axial in Richtung auf die Magnetkörpermitte versetzt ist, wobei die beiden genannten Spulenteile durch axial verlaufende Spulenteile (z. B. 613c, 613d) verbunden sind.

2. Optische Abtasteinheit nach Anspruch 1, dadurch gekennzeichnet, daß sich rings um die Magnetkörpermitte in einer Radialebene eine Ringspule (619) erstreckt, die sich zwischen den genannten Segmentspulen der Spulensätze befindet.

3. Optische Abtasteinheit nach Anspruch 2, dadurch gekennzeichnet, daß alle Segmentspulen der Segmentspulensätze und die Ringspule aus flächenhaften Leitungszügen bestehen, die auf einem zylinderförmigen Träger vorgesehen sind, der den Magnetkörper umschließt.

4. Optische Abtasteinheit nach Anspruch 1, 2 oder 3, dadurch gekennzeichnet, daß zwischen den dauermagnetischen Teilen des Magnetkörpers (903a, 903b) ein Zwischenteil (903c) angeordnet ist, das unmagnetisch, weichmagnetisch oder ebenfalls dauermagnetisch ausgebildet ist.

5. Optische Abtasteinheit nach Anspruch 4, dadurch gekennzeichnet, daß die Nordpole der Teile des Magnetkörpers in Richtung auf das Zwischenteil und die Nordpole des Zwischenteiles zu seiner Außenwand orientiert sind.

6. Optische Abtasteinheit nach Anspruch 4, dadurch gekennzeichnet, daß die Nordpole der Teile des Magnetkörpers zu den axialen Enden und die Nordpole des Zwischenteiles zu seiner Innenwand orientiert sind.

## Claims

1. An optical scanning unit for controlling and directing of a radiation beam on recording trace of a surface to be scanned of an information carrier, the scanning unit comprising an objective having an optical axis, which objective comprises an objective lens for focusing the radiation beam so as to form a scanning spot on said surface, the scanning unit further comprising an electromagnetic actuating device for continuously correcting the position of the objective relative to the information carrier, which actuating device comprises an objective holder for the objective, which objective holder has a movable ring-shaped body (603) arranged to be coaxial with the optical axis, which body has oppositely magnetised magnetic poles at its axial ends and comprises axially superposed permanent-magnetic parts, the actuating device further comprising stationary coils which cooperate magnetically with said magnetic body *via* an air gap and comprise at least three segmental coils sets of two segmental coils (for example 613.1, 615.1) each, which sets are arranged adjacent one another at equal distances viewed in the circumferential direction of the magnetic body, characterised in that each individual coil (for example 613.1) comprises two axially spaced-apart active coil sections (613a, 613b) extending around the magnetic body at equal distances, one of said coil sections being disposed in the proximity of an axial end of the magnetic body which is in its central position and the other coil section being axially offset towards the centre of the magnetic body, which two coil sections are interconnected by axially extending coil elements (613c, 613d).

2. An optical scanning unit as claimed in Claim 1, characterised in that an annular coil (619) extends around the centre of the magnetic body in a radial plane, which coil is interposed between the said segmental coils of the coil sets.

3. An optical scanning unit as claimed in Claim 2, characterised in that all the segmental coils of the segmental coil sets and the annular coil comprise flat conductors arranged on a cylindrical support surrounding the magnetic body.

4. An optical scanning unit as claimed in Claim 1, 2 or 3, characterised in that an intermediate part (903c), which is non-magnetic, soft-magnetic or also permanent-magnetic, is interposed between the permanent-magnetic parts of the magnetic body (903a, 903b).

5. An optical scanning unit as claimed in Claim 4, characterised in that the north poles of the parts of the magnetic body are oriented towards the intermediate part and the north poles of the intermediate part are oriented towards its outer wall.

6. An optical scanning unit as in Claim 4, characterised in that the north poles of the parts of the magnetic body are oriented towards the axial ends and the north poles of the intermediate part are oriented towards its inner wall.

## Revendications

1. Unité d'exploration optique pour commander et diriger un faisceau de rayonnement sur des pistes d'enregistrement d'une surface d'un support d'information devant être explorée, l'unité d'exploration comportant un objectif présentant un axe optique et muni d'une lentille d'objectif pour focaliser le faisceau de rayonnement en un spot d'exploration sur ladite surface, l'unité d'exploration comportant en outre un dispositif d'entraînement électromagnétique pour corriger de façon continue la position de l'objectif par rapport au support d'information et étant muni d'un porte-objectif pour l'objectif, ce porte-objectif présentant un corps annulaire mobile (603) disposé coaxialement avec l'axe optique, corps qui, aux extrémités axiales, est pourvu de pôles magnétiques à aimantations opposées, constitués par des parties à aimantation permanente superposées, le dispositif d'entraînement étant encore muni de bobines stationnaires coopérant magnétiquement avec ledit corps magnétique à travers un entrefer et présentant au moins trois jeux de bobines constituées chacun de deux bobines en segment (par exemple 613.1, 615.1), jeux qui, vus suivant le pourtour du corps magnétique, sont disposés les uns à côté des autres tout en étant séparés par des intervalles égaux, caractérisée en ce que chaque bobine en segment individuelle (par exemple 613.1) présente deux parties de bobine actives (613a, 613b) séparées dans le sens axial et s'étendant autour du corps magnétique, à des distances égales de celui-ci, l'une de ces parties de bobine étant situées à proximité d'une extrémité axiale du corps magnétique situé dans la position centrale et l'autre partie de bobine étant décalée dans le sens axial vers le centre du corps magnétique, lesdites deux parties de bobine étant reliées par des parties de bobine (613c, 613d) s'étendant dans le sens axial.

2. Unité d'exploration optique selon la revendication 1, caractérisée en ce qu'autour du centre du corps magnétique, dans un plan radial, s'étend une bobine toroïdale (619), située entre lesdites bobines en segment du jeu de bobines.

3. Unité d'exploration optique selon la revendication 2, caractérisée en ce que toutes les bobines en segment des jeux de bobines en segment et la bobine toroïdale, sont constituées par des pistes conductrices planes, prévues sur un support cylindrique enfermant le corps magnétique.

4. Unité d'exploration optique selon la revendication 1, 2 ou 3, caractérisée en ce qu'entre les parties à aimantation permanente du corps magnétique (903a, 903b), est disposée une partie intermédiaire (903c) sans aimantation, à aimantation douce ou également à aimantation permanente.

5. Unité d'exploration optique selon la revendication 4, caractérisée en ce que les pôles nord des parties du corps magnétique sont orientés vers la partie intermédiaire et les pôles nord de la partie intermédiaire sont orientés vers sa paroi extérieure.

6. Unité d'exploration optique selon la revendication 4, caractérisée en ce que les pôles nord des parties du corps magnétique sont orientés vers les extrémités axiales et les pôles nord de la partie intermédiaire sont orientés vers sa paroi intérieure.
